# EUROPEAN PATENT APPLICATION

(11) **EP 2 043 157 A1**
(43) Date of publication of application: **01.04.2009**
(21) Application number: 08722464.8
(22) Date of filing: 19.03.2008
(51) Int. Cl.: H01L 29/47, H01L 29/872

(54) **SCHOTTKY BARRIER DIODE AND METHOD FOR MANUFACTURING THE SAME**

(30) Priority: 26.03.2007 JP 2007078275
(71) Applicant: Sumitomo Electric Industries, Ltd., Chuo-ku Osaka-shi Osaka 541-0041 (JP)
(72) Inventor: MIYAZAKI, Tomihito, Osaka-shi Osaka 554-0024 (JP); KIYAMA, Makoto, Osaka-shi Osaka 554-0024 (JP)
(74) Representative: Grünecker, Kinkeldey, Stockmair & Schwanhäusser Anwaltssozietät
(86) International application number: PCT/JP2008/055089
(87) International publication number: WO 2008/117718

(57) **Abstract**

A Schottky barrier diode includes an epitaxial growth layer disposed on a substrate and having a mesa portion, and a Schottky electrode disposed on the mesa portion, wherein a distance between an edge of the Schottky electrode and a top surface edge of the mesa portion is 2 µm or less. Since the distance x is 2 µm or less, a leakage current is significantly decreased, a breakdown voltage is improved, and a Schottky barrier diode having excellent reverse breakdown voltage characteristics is provide.

## Description

### Technical Field

The present invention relates to a Schottky barrier diode, and in particular, to a remediation measure of reverse breakdown voltage characteristics thereof.

### Background Art

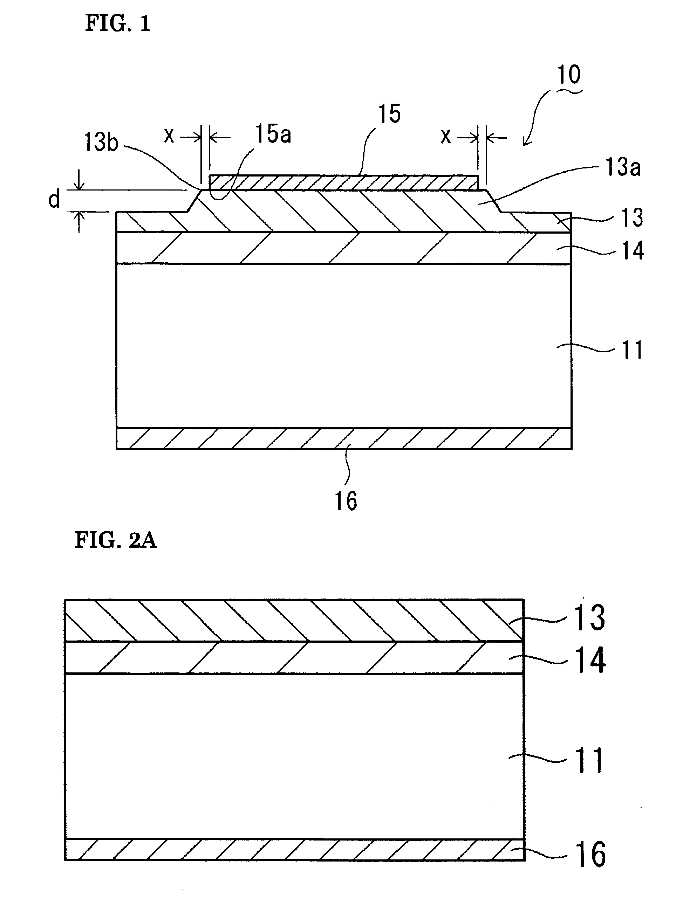

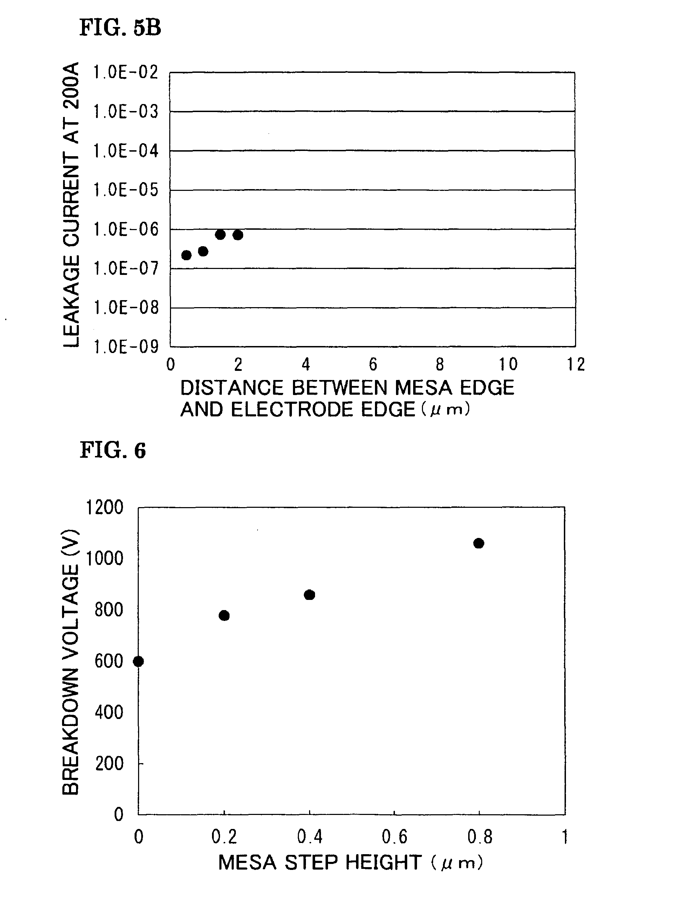

As a technique related to a high-voltage switching element (power device), for example, as disclosed in Figs. 6A and 6B of Patent Document 1, it is known that a GaN layer is formed on a sapphire substrate by epitaxial growth, and a Schottky barrier diode having a mesa structure or a planar structure is then formed on the epitaxial growth layer. Figure 1 of the document shows reverse breakdown voltage characteristics of a GaN rectifier that are theoretically expected when the doping concentration of the epitaxially grown layer is decreased.

Patent Document 1: Japanese Unexamined Patent Application Publication (Translation of PCT Application) No. 2005-530334

### Disclosure of Invention

### Problems to be Solved by the Invention

However, the above document neither discloses specific reverse breakdown voltages that can be actually realized, nor specifically mentions the difference between the planar diode and the diode with a mesa structure.
That is, in the present situation, no significant proposals for characteristic improvement of Schottky barrier diodes for use in power devices, in particular, Schottky barrier diodes with a mesa structure, have been made.

It is an object of the present invention to provide a Schottky barrier diode having satisfactory reverse breakdown voltage characteristics by improving the mesa structure and the structure of a Schottky electrode.

### Means for Solving the Problems

A Schottky barrier diode of the present invention includes a Schottky electrode disposed on an n-type compound semiconductor layer having a mesa portion, wherein a distance between a side edge of the Schottky electrode and a top surface edge of the mesa portion is limited to a predetermined value or less.

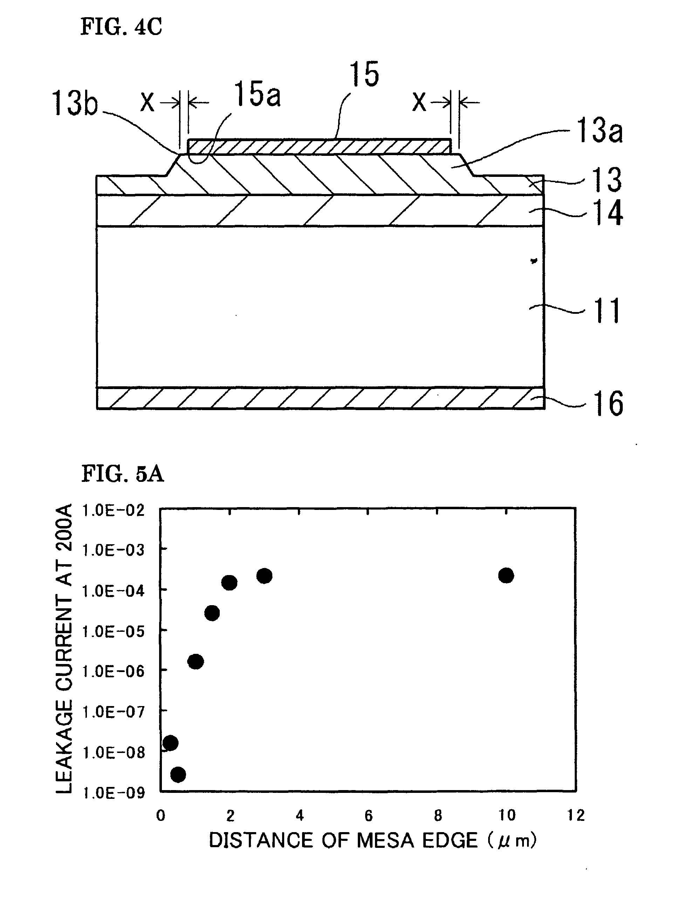

In the Schottky barrier diode of the present invention, an effect of electric field relaxation is obtained at the top surface edge of the mesa portion. Accordingly, as shown in Fig. 5A, it was found that, the smaller the distance between the edge of the Schottky electrode and the edge of the mesa portion, the smaller a leakage current, and thus, a breakdown voltage specified by the leakage current is improved. Accordingly, the reverse breakdown voltage characteristics can be improved by limiting the distance between the edge of the Schottky electrode and the edge of the mesa portion to a predetermined value or less in accordance with the type of Schottky barrier diode.

In particular, as shown in Fig. 5A, the breakdown voltage can be significantly improved by limiting the distance between the edge of the Schottky electrode and the edge of the mesa portion to 2 µm or less.

As shown in Fig. 6, a Schottky barrier diode having a higher breakdown voltage can be obtained when the step height of the mesa portion is more than 0.2 µm.

A first method of producing a Schottky barrier diode (production method 1) of the present invention is a method in which a Schottky electrode is formed, and etching for forming a mesa portion is then performed using a mask membrane.

By controlling the amount of overlap between the mask membrane and the Schottky electrode to be small using this method, the above-described structure of the Schottky barrier diode of the present invention can be easily realized.

In particular, by limiting the amount of overlap between the mask membrane and the Schottky electrode to 2 µm or less, a Schottky barrier diode having particularly excellent reverse breakdown voltage characteristics can be obtained.

A second method of producing a Schottky barrier diode (production method 2) of the present invention is a method in which a mesa portion is formed, a backside electrode is then formed, and subsequently, a Schottky electrode is formed. By production method 2, as shown in Fig. 5B, when the distance between the edge of the Schottky electrode and the edge of the mesa portion is a predetermined value or less, the same working-effect as those in the first production method can be achieved.

In production methods 1 and 2, in the formation of the mesa portion, the outer shape of the mesa portion is formed by plasma etching, and a surface layer may then be removed by wet etching. In such a case, a relatively accurate mesa shape can be efficiently formed by the plasma etching, and in addition, a damage layer formed by the plasma etching can be removed by the wet etching.
It has been found that when such a damage layer remains on the surface of the mesa portion, a leakage current is easily generated due to, for example, a defect level in the damage layer. In particular, as in production method 1, when the distance between the side edge of the Schottky electrode and the top surface edge of the mesa portion is limited to a predetermined value or less, a leakage current due to the damage layer is easily generated. The generation of such a leakage current can be suppressed by removing the damage layer by wet etching. Consequently, a Schottky barrier diode having a higher breakdown voltage can be obtained.

### Advantages

According to the Schottky barrier diode and the method of producing the Schottky barrier diode of the present invention, the reverse breakdown voltage characteristics can be improved.

### Brief Description of Drawings

Figure 1 is a cross-sectional view of a Schottky barrier diode according to an embodiment.
Figure 2A is a cross-sectional view showing a step of producing a Schottky barrier diode (forming a buffer layer, an epitaxial layer, and a backside electrode) according to production method 1-1.
Figure 2B is a cross-sectional view showing a step of producing the Schottky barrier diode (forming a Schottky electrode) according to production method 1.
Figure 2C is a cross-sectional view showing a step of producing the Schottky barrier diode (forming a resist mask covering the upper surface and the side surface of the Schottky electrode) according to production method 1.
Figure 2D is a cross-sectional view showing a step of producing the Schottky barrier diode (etching the epitaxial growth layer and then removing the resist mask) according to production method 1.
Figure 3A is a cross-sectional view showing a step of producing a Schottky barrier diode (forming a buffer layer and an epitaxial layer) according to production method 1-1.
Figure 3B is a cross-sectional view showing a step of producing the Schottky barrier diode (forming a Schottky electrode) according to production method 1-1.
Figure 3C is a cross-sectional view showing a step of producing the Schottky barrier diode (forming a resist mask covering the upper surface and the side surface of the Schottky electrode) according to production method 1-1.
Figure 3D is a cross-sectional view showing a step of producing the Schottky barrier diode (etching the epitaxial growth layer) according to production method 1-1.
Figure 3E is a cross-sectional view showing a step of producing the Schottky barrier diode (forming a backside electrode) according to production method 1-1.
Figure 4A is a cross-sectional view showing a step of producing a Schottky barrier diode (forming a mesa portion on an epitaxial growth layer, and then removing a resist mask) according to production methods 2-1 and 2-2.
Figure 4B is a cross-sectional view showing a step of producing the Schottky barrier diode (removing the resist mask and forming a backside electrode) according to production methods 2-1 and 2-2.
Figure 4C is a cross-sectional view showing a step of producing the Schottky barrier diode (forming a Schottky electrode) according to production methods 2-1 and 2-2.
Figure 5A is a graph showing measured data of leakage current characteristics of a Schottky barrier diode produced by production method 1-1.
Figure 5B is a graph showing measured data of leakage current characteristics of a Schottky barrier diode produced by production method 2-1.
Figure 6 is a graph showing measured data of the breakdown voltage of Schottky barrier diodes produced by production methods 1-1 and 2-1 as a function of mesa step height.

### Reference Numerals

10 Schottky barrier diode
11 GaN substrate
11a upper portion
13 epitaxial growth layer
13a mesa portion
13b top surface edge
15 Schottky electrode
15a edge
16 backside electrode
20 resist mask

### Best Modes for Carrying Out the Invention

Embodiments of the present invention will now be described. In the description of the drawings, the same elements are assigned the same reference numerals, and overlapping description is omitted. Note that the dimensional ratios in the drawings do not always correspond to those in the description.

### EXAMPLES

### First Embodiment

### - The structure of Schottky barrier diode -

Figure 1 is a cross-sectional view showing the structure of a Schottky barrier diode according to an embodiment of the present invention.

As shown in Fig. 1, a Schottky barrier diode 10 according to this embodiment includes a freestanding GaN substrate 11 having a thickness of about 400 µm and an epitaxial growth layer 13 provided on the GaN substrate 11 and having a thickness of about 7 µm. The epitaxial growth layer 13 has a mesa portion 13a projecting upward from the bottom thereof. In this embodiment, the side surface of the mesa portion 13a has a slanted shape. Alternatively, the side surface may be a perpendicular wall. A Schottky electrode 15 made of Au is provided on the top surface of the mesa portion 13a. In plan view, the Schottky electrode 15 has a circular shape having a diameter of about 200 µm. Furthermore, an ohmic backside electrode 16 made of Ti/Al/Ti/Au is provided on the reverse surface of the GaN substrate 11.

The main body of the GaN substrate 11 contains an n-type dopant having a relatively high concentration of about 3 × 10¹⁸ cm⁻³. The epitaxial growth layer 13 (drift layer) contains an n-type dopant having a low concentration of about 5 × 10¹⁵ cm⁻³. The region with a thickness of about 1 µm between the epitaxial growth layer 13 and the GaN substrate 11 is a buffer layer 14 which contains a dopant having a relatively low concentration of about 1 × 10¹⁷ cm⁻³_{.}

In the Schottky barrier diode 10 of this embodiment, a distance x between an edge 15a of the Schottky electrode 15 and a top surface edge 13b of the mesa portion 13a is 2 µm or less. Such a structure is realized by production method 1 or 2 described below. In addition, a mesa step height d (mesa thickness) in this embodiment, which is the distance between the mesa portion 13a and the bottom thereof, is 0.2 µm or more, for example, about 1 µm.

### - Steps of producing Schottky barrier diode -

### Production method 1-1

Figures 2A to 2D are cross-sectional views showing steps producing a Schottky barrier diode according to production method 1.
First, in the step shown in Fig. 2A, a buffer layer 14 and an epitaxial growth layer 13 are grown on a GaN substrate 11. In the growth, an n-type dopant with a carrier density of about 1 × 10¹⁷ cm⁻³ is added to the buffer layer 14, and an n-type dopant with a carrier density of about 5 × 10¹⁵ cm⁻³ (1 × 10¹⁶ cm⁻³ or less) is added to the epitaxial growth layer 13 using a known metal organic chemical vapor deposition. Alternatively, the epitaxial growth layer 13 may be an undoped layer. Next, organic cleaning is performed, and cleaning is further performed using 10% hydrochloric acid for three minutes. Subsequently, Ti/Al/Ti/Au films (thicknesses: 20/100/20/200 nm) which are multilayers are deposited on the reverse surface of the GaN substrate 11 by an evaporation method. An alloying heat treatment is performed at 600°C for two minutes to form a backside electrode 16 that is in ohmic contact with the GaN substrate 11.

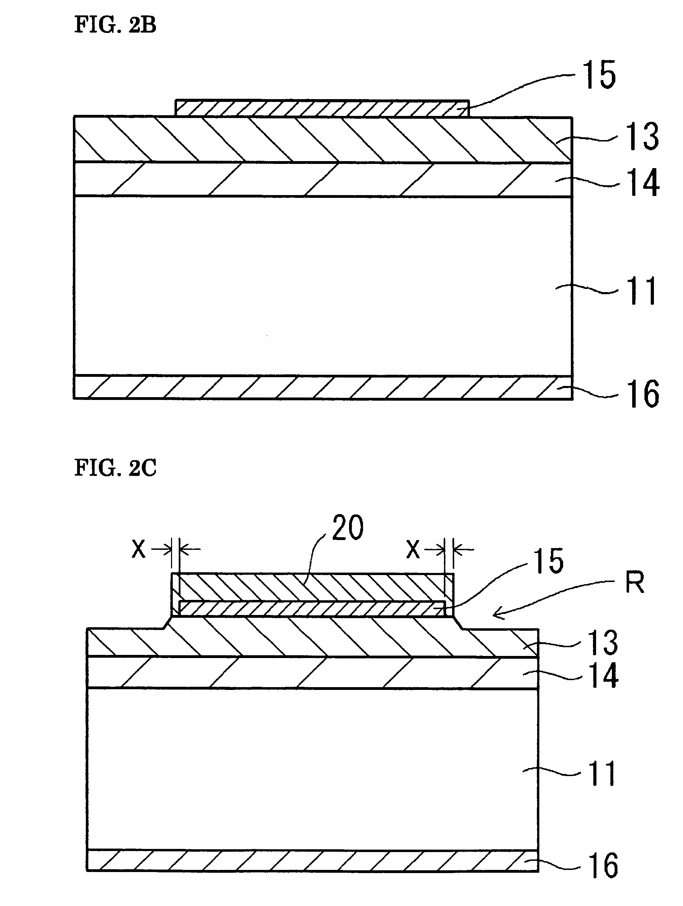

Next, in the step shown in Fig. 2B, organic cleaning is performed, and cleaning is further performed using 10% hydrochloric acid for three minutes. Subsequently, a Schottky electrode 15 composed of a Au film with a thickness of about 400 nm which has been formed by an evaporation method is formed on the epitaxial growth layer 13 by a known lift-off technology. As described above, in plan view, the Schottky electrode 15 has a circular shape having a diameter of about 200 µm.

Next, in the step shown in Fig. 2C, a resist mask 20 covering the upper surface and the side surface of the Schottky electrode 15 is formed. The resist mask 20 is composed of a photoresist resin such as a novolac resin and has a diameter 2 µm larger than that of the Schottky electrode 15. Accordingly, even when an alignment error of a mask is considered, the Schottky electrode 15 is reliably covered with the resist mask 20 around the circumference of the Schottky electrode 15. In addition, the distance x between the edge of the resist mask 20 and the edge of the Schottky electrode 15 is 2 µm or less at any position of the Schottky electrode 15. However, it is sufficient that at least the upper surface of the Schottky electrode 15 is covered. In addition to photoresist resins, other examples of the material constituting an etching mask include SiN, SiON, SiO₂, Au, Pt, W, Ni, and Ti. Alternatively, the Schottky electrode itself can be used as the etching mask. In such a case, the distance x can be zero by a self-alignment.

Subsequently, in the state in which the resist mask 20 is provided, the epitaxial growth layer 13 is etched using a parallel-plate type reactive ion etching (RIE) apparatus while Cl₂ and BCl₂ are supplied as etching gases. Regarding etching conditions of this example, the power density is 0.004 W/mm², the pressure in a chamber is in the range of 10 to 200 mTorr, the electrode temperature is in the range of 25°C to 40°C, and the gas flow rate of Cl₂ is 40 sccm and the gas flow rate of BCl₂ is 4 sccm. However, the etching conditions are not limited to the above conditions.

Only Cl₂ may be used as an etching gas. Alternatively, for example, Cl₂ and Ar, Cl₂ and N₂, Cl₂ and BCl₂, or N₂ may be used. Damage to the epitaxial growth layer 13 can be suppressed as much as possible by using these etching gases. Note that the plasma generator is not limited to an RIE apparatus, and another plasma generator such as an inductively coupled plasma (ICP) apparatus can also be used.

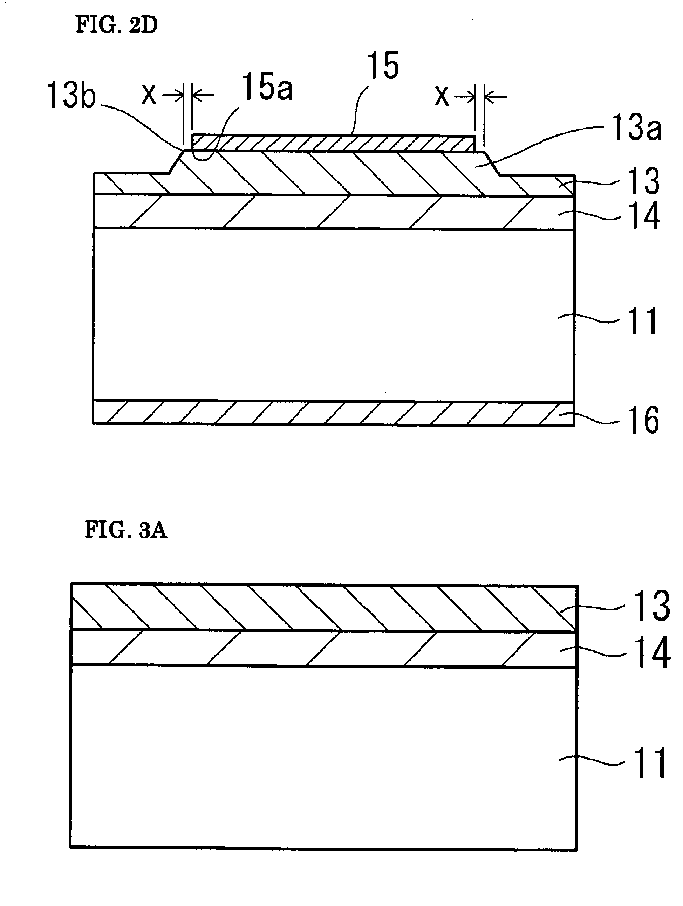

Next, in the step shown in Fig. 2D, the etching is stopped at the time when the epitaxial growth layer 13 is etched to a depth of 1 µm, and the resist mask 20 is then removed by ashing or the like. Thereby, the outer shape of a mesa portion 13a is formed. The steps of producing the Schottky barrier diode are completed. In this state, the distance x between a top surface edge 13b of the mesa portion 13a and an edge 15a of the Schottky electrode 15 is 2 µm or less around the circumference of the Schottky electrode 15.

### Production method 1-2

Figures 3A to 3E are cross-sectional views showing steps of producing a Schottky barrier diode according to production method 1-2.
First, in the step shown in Fig. 3A, a buffer layer 14 and an epitaxial growth layer 13 are grown on a GaN substrate 11 under the same conditions as in production method 1-1. However, the backside electrode 16 is not formed.

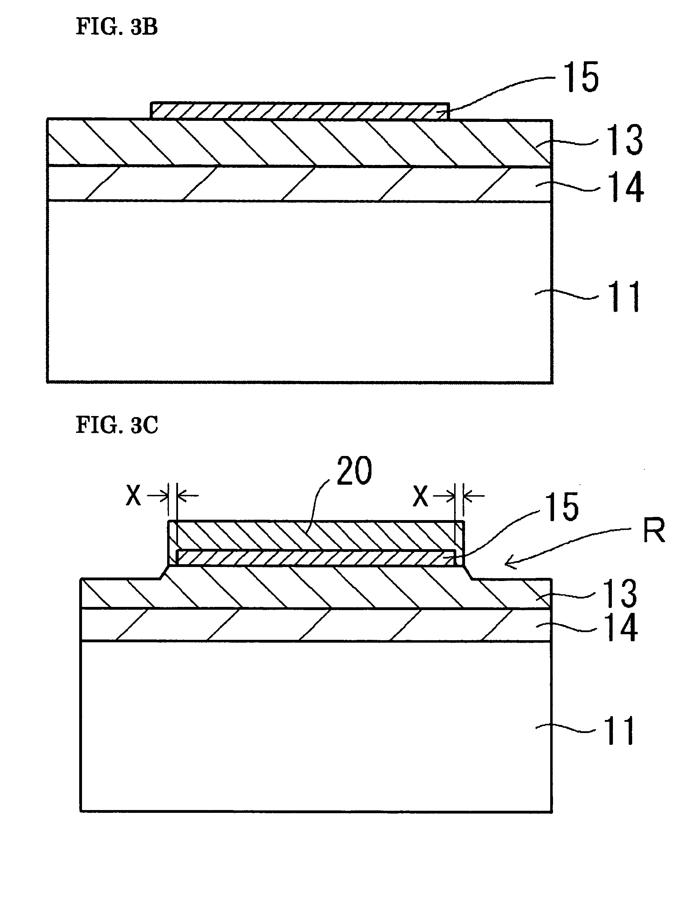

Next, in the steps shown in Figs. 3B and 3C, a Schottky electrode 15 made of a Au film or a Ni/Au film is formed under the same conditions as in production method 1-1, and a resist mask 20 covering the upper surface and the side surface of the Schottky electrode 15 is then formed.
However, it is preferable that the distance x shown in Fig. 3C is at least equal to or larger than the amount removed by subsequent wet etching.

Subsequently, in the state in which the resist mask 20 is provided, the epitaxial growth layer 13 is plasma etched using a parallel-plate type RIE apparatus. In this step, the same etching gases as those used in production method 1-1 can be used under the same conditions. The plasma generator used is not limited to an RIE apparatus, and another plasma generator such as an ICP apparatus can also be used.

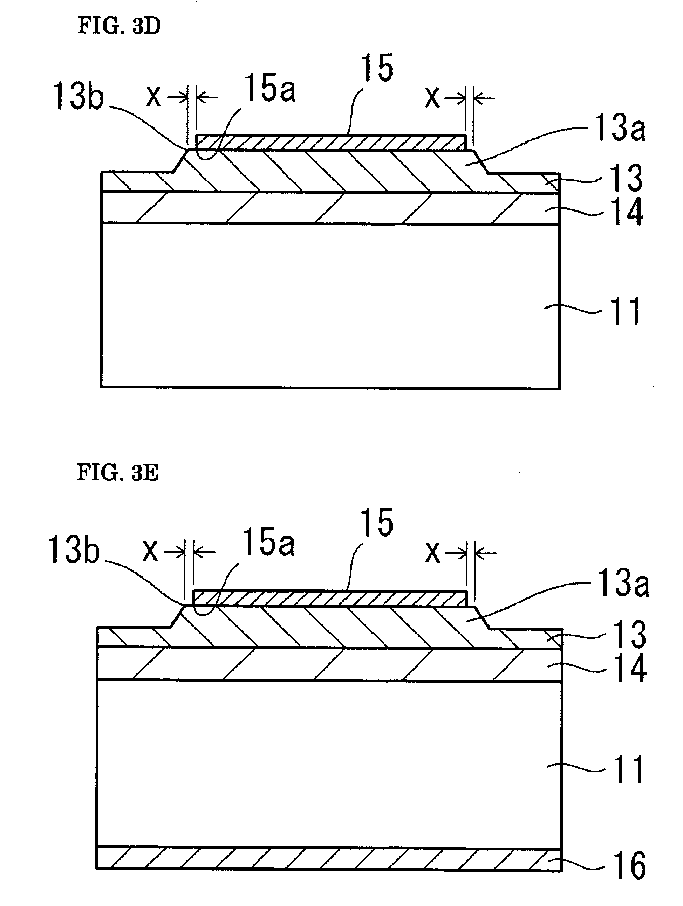

Next, in the step shown in Fig. 3D, the plasma etching is stopped at the time when the epitaxial growth layer 13 is etched to a depth of 1 µm, and the resist mask 20 is then removed by ashing or the like. The outer shape of a mesa portion 13a is formed by this plasma etching.

Subsequently, the entire substrate is immersed in a 25% aqueous solution of tetramethylammonium hydroxide (TMAH), and wet etching of GaN is performed at a temperature of about 85°C. A damage layer formed on the surface of the epitaxial growth layer 13 by the above-mentioned plasma etching is removed by this treatment. An etching damage layer is formed to a depth of several nanometers (in the range of about 1 to 20 nm) on the surface of the epitaxial growth layer 13a including the mesa portion 13a, though the etching damage layer is different depending on the type of plasma generator used and conditions of the plasma etching. This wet etching is performed until the etching damage layer is substantially removed. The term "substantially removed" means that it is sufficient that the etching damage layer is removed to the extent that the etching damage layer does not affect the leakage current described below even though the etching damage layer is not completely removed.

In the step shown in Fig. 3D, a treatment for removing the resist mask 20 by ashing or the like is not always necessary. This is because the resist mask 20 can also be removed depending on the time of the wet etching using the 25% aqueous solution of TMAH.

The etchant used for performing the wet etching is not limited to an aqueous solution of TMAH, and another appropriate etchant can be used in accordance with the material of the substrate (GaN in this embodiment). In the case where an aqueous solution of TMAH is used, the concentration of the solution is not limited to 25%, and the concentration and other conditions such as the temperature can be appropriately selected.

Next, in the step shown in Fig. 3E, organic cleaning is performed, and cleaning is further performed using 10% hydrochloric acid for three minutes. Subsequently, Ti/Al/Ti/Au films (thicknesses: 20/100/20/200 nm) which are multilayers are deposited on the reverse surface of the GaN substrate 11 by an evaporation method. An alloying heat treatment is performed at 450°C for two minutes (note: please check this condition) to form a backside electrode 16 that is in ohmic contact with the GaN substrate 11. In this step, the alloying treatment of the backside electrode 16 is performed under temperature and time conditions for which a Schottky contact between the Schottky electrode 15 and the epitaxial growth layer 13 is maintained.

### Production method 2-1

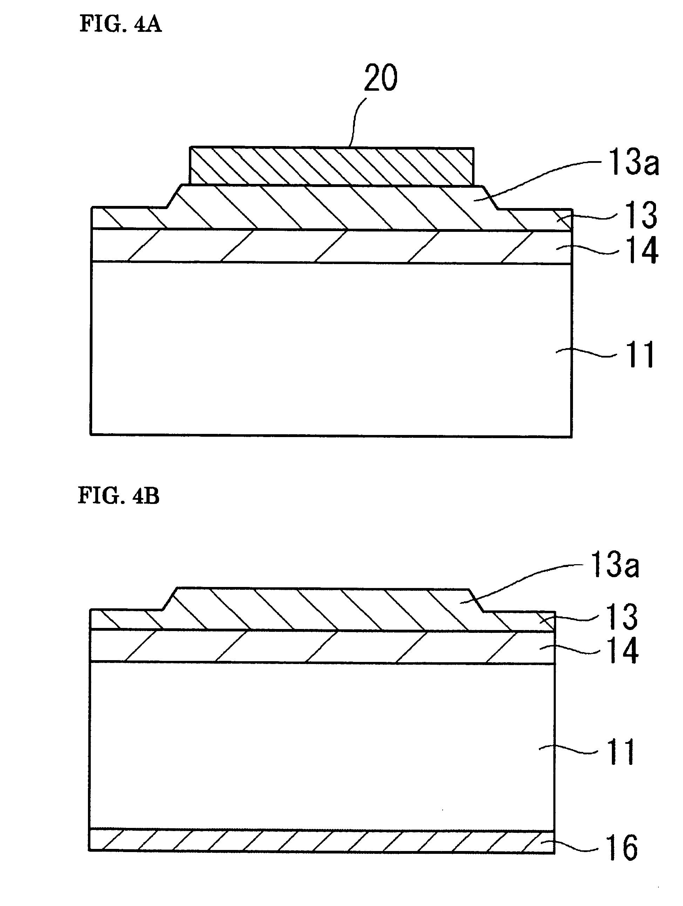

Figures 4A to 4C are cross-sectional views showing steps of producing a Schottky barrier diode according to production method 2-1.
First, in the step shown in Fig. 4A, an epitaxial growth layer is grown under the same conditions as in production method 1-1, and a resist mask 20 similar to that used in production method 1-1 is then formed on a mesa portion 13a. In the state in which the resist mask 20 is provided, the epitaxial growth layer 13 is plasma etched. The plasma generator used and plasma etching conditions are the same as those used in production method 1-1.

Next, in the step shown in Fig. 4B, the resist mask 20 is removed, and a backside electrode 16 is then formed on the reverse surface of the GaN substrate 11. The forming conditions, the material, and the conditions for the alloying treatment of the backside electrode 16 are the same as those used in production method 1-1.

Furthermore, in the step shown in Fig. 4C, a Schottky electrode 15 having a diameter 2 µm smaller than that of the resist mask 20 is formed. The formation method is the same as production method 1-1.
That is, in production method 2-1, only the processing order is changed from that of production method 1-1.
By the above-described process, the Schottky barrier diode in which the distance x between a top surface edge 13b of the mesa portion 13a and an edge 15a of the Schottky electrode 15 is 2 µm or less is formed.
However, as shown by data described below, when the production steps of production method 2-1 are employed, the leakage current can be reduced by limiting the distance x between the top surface edge 13b of the mesa portion 13a and the edge 15a of the Schottky electrode 15 to a predetermined value (2 µm in this example) or less.

### Production method 2-2

In production method 2-2, steps which are fundamentally the same as the steps shown in Figs. 4A to 4C in production method 2-1 are performed.
However, in production method 2-2, in the step shown in Fig. 4B, before the backside electrode 16 is formed, a damage layer formed on the surface of the epitaxial growth layer 13 by the plasma etching is removed by wet etching using a 25% aqueous solution of TMAH under the same conditions as in production method 1-2.

Alternatively, after the backside electrode 16 is formed, wet etching using a 25% aqueous solution of TMAH may be performed. In such a case, it is preferable that an etching protective film is formed on the reverse surface of the GaN substrate 11 so as to cover the backside electrode 16. As the etching protective film, an insulating film having a resistance against the 25% aqueous solution of TMAH, for example, a silicon oxide film or a silicon nitride film, can be used. Subsequently, the insulating film is removed using a known etchant suitable for the material of the insulating film, and the step shown in Fig. 4C can be performed.

### - Characteristics of Schottky barrier diodes -

Figures 5A and 5B are graphs showing measured data of leakage current characteristics of Schottky barrier diodes produced by production methods 1-1 and 2-1, respectively. In Figs. 5A and 5B, the horizontal axis represents the distance x between the top surface edge 13b of the mesa portion 13a and the edge 15a of the Schottky electrode 15, and the vertical axis represents the leakage current (A) when a reverse voltage of 200 V is applied.

As shown in Fig. 5A, in the Schottky barrier diodes produced by production method 1-1, a tendency that the leakage current decreases with a decrease in the distance x is significantly observed. The leakage current is a parameter of a threshold for determining a breakdown voltage. Therefore, a small leakage current means a high breakdown voltage. Accordingly, as in the present invention, by limiting the distance x between the top surface edge 13b of the mesa portion 13a and the edge 15a of the Schottky electrode 15 to a predetermined value or less, the breakdown voltage of the Schottky barrier diode can be improved.

In particular, by limiting the distance x to 2 µm or less, the leakage current is significantly decreased. Accordingly, it is found that the breakdown voltage is also markedly improved.
In contrast, as in Patent Document 1, in the case where a semiconductor layer that is epitaxially grown on a substrate (e.g., a sapphire substrate) other than a freestanding GaN substrate is used, many defects such as dislocation are contained. Accordingly, even if the mesa structure and the structure of a Schottky electrode are improved, a satisfactory improvement of characteristics may not be achieved. On the other hand, by using a freestanding GaN substrate (bulk substrate), the advantage of the present invention can be significantly achieved.

As shown in Fig. 5B, in the Schottky barrier diodes produced by production method 2-1, similarly, the tendency that the leakage current decreases with a decrease in the distance x is observed. Accordingly, the Schottky barrier diodes produced by production method 2 also achieve the effect of improvement in the breakdown voltage as in the case of production method 1.

Figure 6 is a graph showing measured data of the breakdown voltage of Schottky barrier diodes produced by production methods 1-1 and 2-1 as a function of mesa step height d. As shown in the figure, the breakdown voltages are improved as compared with the case where the mesa step height d is zero. As the mesa step height d increases, the breakdown voltage improves. That is, by using the mesa structure, the breakdown voltage is improved compared with a Schottky barrier diode having a planar structure. When the mesa step height d is 0.2 µm or more, the breakdown voltage is about 800 (V) or more, and thus, a significant improvement in the breakdown voltage is observed.

In production methods 1-1 and 2-1, when plasma etching for forming the mesa portion 13a is performed, a damage layer formed by the plasma etching remains on the surface of the epitaxial growth layer 13 including the mesa portion 13a. Accordingly, a leakage current is easily generated due to a defect level in this damage layer. In addition, it is known that when the distance x between the top surface edge 13b of the mesa portion 13a and the edge 15a of the Schottky electrode 15 is limited to a predetermined value or less, as in the present invention, a leakage current due to the damage layer is easily generated.
In this respect, it is expected that the leakage current shown in Figs. 5A and 5B can be further decreased by removing the damage layer.

That is, as in production methods 1-2 and 2-2 described above, by performing wet etching for removing the damage layer due to plasma etching, a Schottky barrier diode having a higher breakdown voltage can be provided.
In addition, in the plasma etching for forming the mesa portion 13a, when the etching efficiency is increased, the depth of the damage layer is also increased. In contrast, when the damage depth is reduced, the etching efficiency is degraded because the plasma etching is performed under mild conditions. Accordingly, by introducing wet etching after plasma etching, the efficiency for forming the mesa portion 13a can also be improved.

In the above embodiments, a description has been made of examples in which a GaN substrate and a GaN epitaxial growth layer are provided as semiconductor layers. However, the Schottky barrier diode of the present invention can also be applied to SiC or Si.

In the above-described embodiments, in particular, in production method 2, the Schottky electrode 15 may protrude from the upper surface of the mesa portion 13.

The structures of the above-disclosed embodiments of the present invention are given as examples only, and the scope of the present invention is not limited to the ranges described in these embodiments. The scope of the present invention is specified by the description of the claims, and further includes the meaning equivalent to the description of the claims and all changes within the scope thereof.

### Industrial Applicability

The present invention can be used as a connector that establishes an electrical connection of wirings between a wiring board and a multicore coaxial cable installed in electrical equipment such as a portable phone.

## Claims

1. A Schottky barrier diode comprising:
a semiconductor layer having a mesa portion; and
a Schottky electrode disposed on the top surface of the mesa portion,
wherein a distance between a side edge of the Schottky electrode and a top surface edge of the mesa portion is a predetermined value or less.

2. The Schottky barrier diode according to claim 1,
wherein the predetermined value is 2 µm.

3. The Schottky barrier diode according to claim 1 or 2,
wherein a step height of the mesa portion is more than 0.2 µm.

4. A method of producing a Schottky barrier diode comprising:
step A of forming a Schottky electrode on a semiconductor layer; and
step B of forming a mesa shape by etching the semiconductor layer using the Schottky electrode or a mask membrane, step B being performed after step A.

5. The method of producing a Schottky barrier diode according to claim 4,
wherein, in step B, a resist film in which the amount of overlap with the Schottky electrode is 2 µm or less is used as the mask membrane.

6. The method of producing a Schottky barrier diode according to claim 4 or 5,
wherein, in step A, the outer shape of a mesa portion is formed by plasma etching, and a surface layer is then removed by wet etching.

7. A method of producing a Schottky barrier diode comprising:
step A of forming a mesa portion by etching a semiconductor layer disposed on a principal surface side of a substrate;
step B of forming a backside electrode on a reverse surface of the substrate, step B being performed after step A; and
step C of forming a Schottky electrode on the mesa portion, step C being performed after step B.

8. The method of producing a Schottky barrier diode according to claim 7,
wherein, in step A, the outer shape of the mesa portion is formed by plasma etching, and a surface layer is then removed by wet etching.
